# EUROPEAN PATENT APPLICATION

(11) **EP 1 501 130 A1**
(43) Date of publication of application: **26.01.2005**
(21) Application number: 03425483.9
(22) Date of filing: 21.07.2003
(51) Int. Cl.: H01L 29/423, H01L 21/28

(54) **Semiconductor MOS device and related manufacturing method**

(71) Applicant: STMicroelectronics S.r.l., 20041 Agrate Brianza (Milano) (IT)
(72) Inventor: Pio, Federico, 20047 Brugherio (MI) (IT); Gomiero, Enrico, 20062 Cassano d'Adda (MI) (IT)
(74) Representative: Mittler, Enrico

(57) **Abstract**

A MOS semiconductor device comprising an active area (1) of semiconductor material is described. The active area (1) comprises a central part (10) and an edge (9) having a inclined surface with respect to the central part (10). The MOS device comprises a gate finger (2) placed over of the central part (10) of said active area and formed by an insulating material layer (11) adjacent to the active area (1) and a conductive material layer (20) over said insulating material layer (11). The MOS device comprises at least one first pair of prolongations (51, 61, 71, 72) of said gate finger (2) which derive from both its opposite sides (49) transversal to the formation of the channel under the gate finger (2) and which fmd in a direction substantially parallel to the formation of said channel. Said first pair of prolongations (51, 61, 71, 72) are placed over portions (48) of the edge (9) of the active area (1) which are parallel to the formation of said channel and over their adjacent portions (21) of the central part of the active area (1).

## Description

The present invention relates to a MOS semiconductor device and to a related manufacturing method.

In the present semiconductor devices of the MOS type an isolation technology with low depth trenches is typically employed which is indicated as STI (Shallow Trench Isolation) technology for reducing the area assigned to the device and for improving the integrability thereof.

A disadvantage of this technology consists of the possibility of achieving non ideal transistors: more specifically it often happens that said transistors have an anomalous conduction in sub-threshold region, that is even typically called hump effect. The consequence of the hump effect consists of a consistent increase of the tuming-off current of the MOS transistor when for example the gate terminal is connected to ground and of a deviation from the normal exponential waveform of the sub-threshold current with annexed increase of the sub-threshold current slope.

This causes an increase of the power consumption of the integrated circuit where some transistors in off state are which will conduct a certain current.

Another effect consists of a huge impact on the main features of some circuits exploiting the current or voltage slope in sub-threshold region, as for example the bandgap regulator circuit where the deviation from the exponential waveform of the sub-threshold current can determine a not stable output voltage regulation that is not acceptable for said circuits.

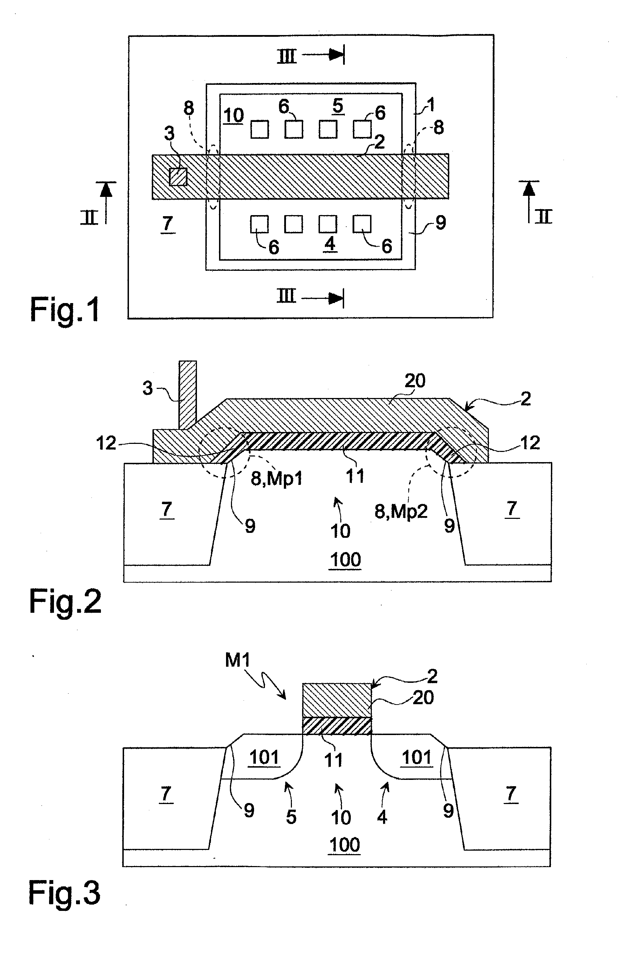

In Figure 1 a layout of a semiconductor MOS device formed in STI technology is shown which comprises an active area 1 (wherein as active area is intended the set of the source, drain and channel regions of the MOS device) having upward a gate finger 2 provided with a related contact 3 outside the active area 1. The part 4 of the active area 1 which in Figure 1 is under the gate finger 2 acts as drain or source of a MOS transistor M1 while the part 5 of active area 1 above the gate finger 2 acts respectively as source or drain of the MOS transistor M1. The last is shown in more detailed manner in Figure 3, that is a section of the layout of Figure 1 which is parallel to the formation of the channel in the MOS transistor M1 where the source and drain regions 101 which belong to the active area 1 and are formed on the substrate 100 are shown. The active area 1 is surrounded by field oxide 7 and comprises areas 6 for contacting the drain and the source regions. The regions 8, in dashed lines in Figure 1, are the regions of the device which are responsible of the hump effect.

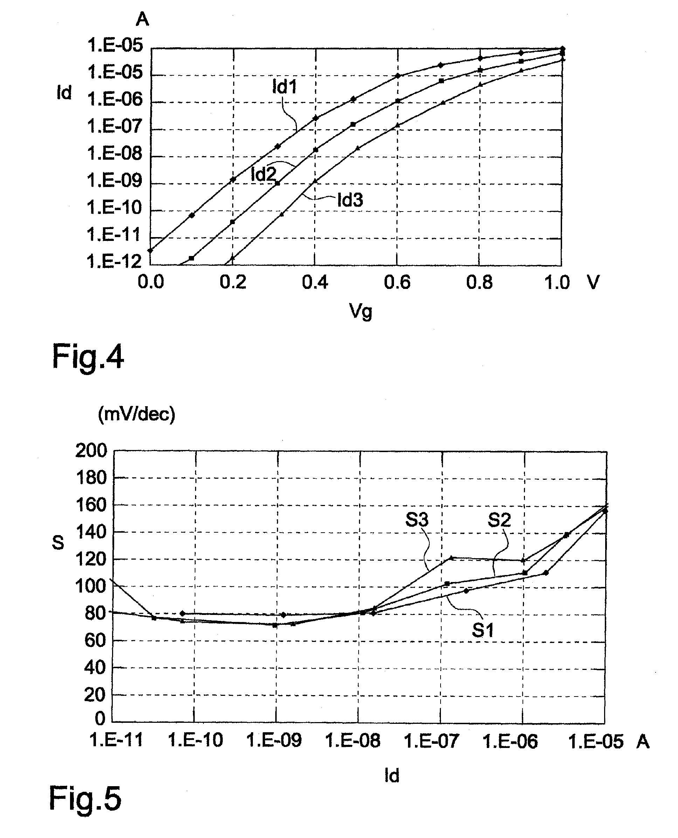

Such regions 8 are on the edge 9 of the active area 1 which has a slope of an angle smaller than a right angle with respect to the surface profile of the central part 10 of the active area 1, as it is shown in more detailed manner in Figure 2 where a section of the device in Figure 1 along a transverse line to the formation of the channel of the MOS transistor M1 is shown. Such slope is due to the fact that the active area has been submitted to an attack for forming the trenches where the filed oxide has been placed. The gate finger 2 comprises a polysilicon layer 20 and a silicon oxide layer 11; the last can present a higher thickness over the central part 10 and a lower thickness on the edge 9 of the active area 1. It is possible that the dopant concentration of the active area 1 is higher in the central part 10 than in the edge 9. The fact that the thickness of the two silicon oxide zones 12 above the edge 9 of the active area 1 and under the polysilicon layer 20 is lower than the silicon oxide layer 11 of the gate finger 2 placed over the central part 10 of the active area 1 or that the dopant concentration in the edge 9 is lower than in the central part 10 of the active area 1 causes the formation of two parasitic transistors Mp1 and Mp2 which have a threshold voltage lower than that of the main MOS transistor M1. The transistors Mp1 and Mp2 are formed parallel to the main MOS transistor M1; the source and drain zones are constituted by the zones of the edge 9 of the active area 1 which are near the gate finger 2. The current driven by the main MOS transistor is given by the channel current and the current flowing through the parasitic transistors Mp1 and Mp2. The lasts, having a threshold voltage lower than the main MOS transistor, will be turned on by means a lower gate voltage and therefore they will be turned on before the main MOS transistor. In other hand, since the width of the zone of the semiconductor device which is dedicated to each parasitic transistor is narrower than that dedicated to the main transistor, the current flowing through the transistor Mp1 and Mp2 between the source and drain terminals saturates at a lower value than that of the main transistor. Therefore, by considering the current Id (shown in Figure 4) as sum of the currents of the main transistor and of the parasitic transistors, the formation of a transition region occurs where the sum of the two contributes can be seen. In Figure 4 the waveform of the current Id as a function of the gate voltage Vg according to the different substrate bias voltages Vb (that is Id1 with Vb=0, Id2 with Vb=-0.5V and Id3 with Vb=-1V) is shown while the Figure 5 shows the slope S given by dVg/(dlog(Id)) ( at millivolt/decade) as a function of the current Id according to the different substrate bias voltages Vb (that is S1 with Vb=0V, S2 with Vb=-0.5V and S3 with Vb=-1V).

In view of the art described, it is an object to present invention to provide a MOS semiconductor device which overcomes the aforementioned drawbacks.

According to the present invention, this object is obtained by means of a MOS semiconductor device comprising an active area of semiconductor material, said active area comprising a central part and an edge having a inclined surface with respect to the central part, said MOS device comprising a gate finger placed over of the central part of said active area and formed by an insulating material layer adjacent to the active area and a conductive material layer over said insulating material layer, characterized by comprising at least one first pair of prolongations of said gate finger which derive from both its opposite sides transversal to the formation of the channel under the gate finger and which find in a direction substantially parallel to the formation of said channel, said first pair of prolongations being placed over portions of the edge of the active area which are parallel to the formation of said channel and over their adj acent portions of the central part of the active area.

According to the present invention is possible to form a semiconductor MOS device manufacturing method as defined in claim 10.

The features and the advantages of the present invention will be made evident by the following detailed description of embodiments thereof, shown as not limiting examples in the annexed drawings, wherein:
Figure 1 is a layout of a MOS semiconductor transistor according to prior art;
Figure 2 is a section of the device in Figure 1 according to line II-II;
Figure 3 is a section of the device in Figure 1 according to line III-III;
Figure 4 shows the current flowing in the MOS transistor in Figure 1 as a function of the gate voltage with different substrate bias voltages;
Figure 5 shows the slope of the drain current of the transistor in Figure 1 as a function of the same current;
Figure 6 shows a layout of a MOS semiconductor device according to a first embodiment of the present invention;
Figure 7 is a section according to line VII-VII of the device in Figure 6;
Figure 8 is a section according to line VIII-VIII of the device in Figure 6;
Figure 9 shows the current flowing in the MOS device in Figure 6 as a function of the gate voltage with different substrate bias voltages;
Figure 10 shows the slope of the drain current of the transistor in Figure 6 as a function of the same current;
Figure 11 shows a schematic circuit to which the device in Figure 6 is equivalent;
Figure 12 shows a layout of a MOS semiconductor device according to a second embodiment of the present invention;
Figure 13 shows a layout of a MOS semiconductor device according to a variant of the second embodiment of the present invention;
Figure 14 shows a layout of a MOS semiconductor device according to a third embodiment of the present invention.

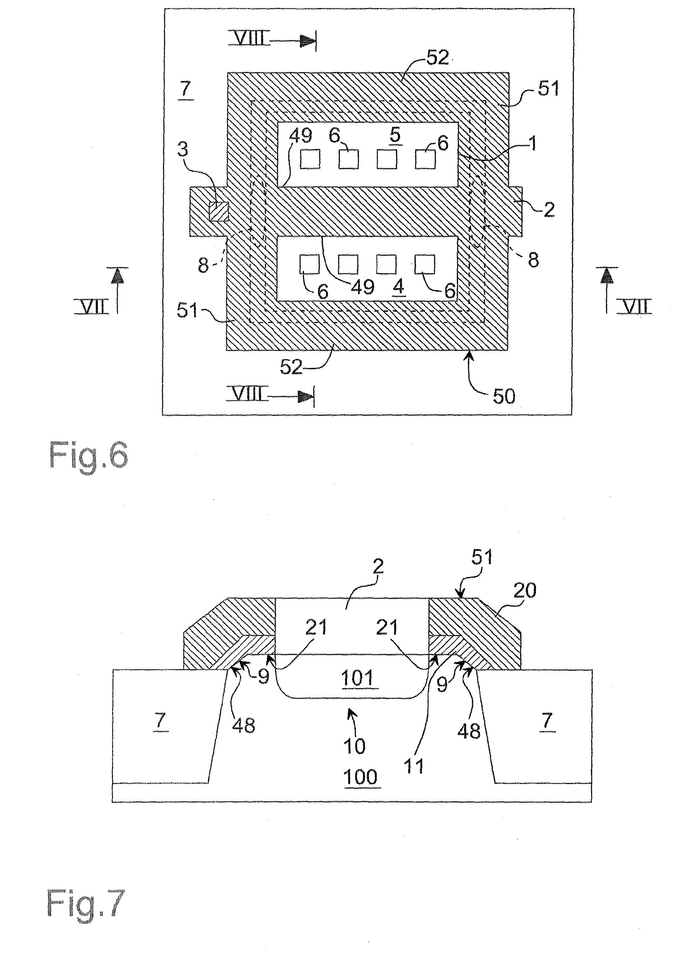

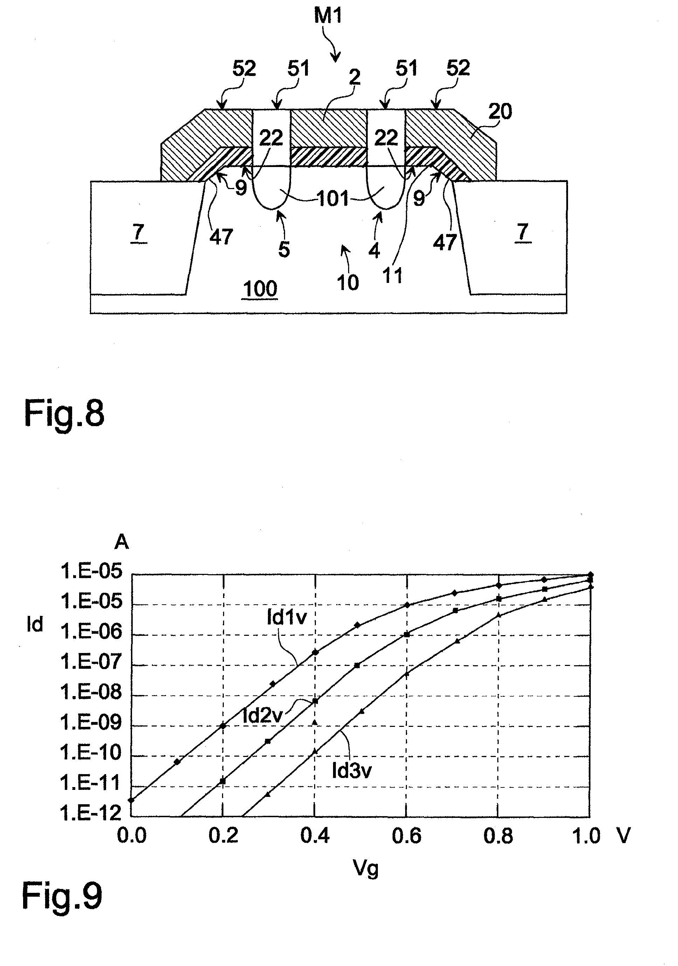

Referring to Figures 6-8 a MOS semiconductor device according to a first embodiment of the present invention is shown; the elements equal to the device in Figure 1 will be indicated by means of the same numeric references. Said MOS semiconductor device comprises an active area 1 (wherein as active area is intended the set of the source, drain and channel regions of the MOS device) having upward a gate finger 2 provided with a related contact 3 outside the active area 1; the semiconductor MOS device comprises the transistor M1. The part 4 of the active area 1 which in Figure 6 is under the gate finger 2 acts as drain or source of a MOS transistor M1 while the part 5 of active area 1 which in Figure 6 is above the gate finger 2 acts respectively as source or drain of the MOS transistor M1. The last is shown in more detailed manner in Figure 8, that is a section of the layout of Figure 6 which is parallel to the formation of the channel in the MOS transistor M1, where the source and drain regions 101 which belong to the active area 1 and are formed on the substrate 100 are shown. Over the active area 1 contact areas 6 for contacting the drain and the source regions are placed; the active area 1 is surrounded by field oxide 7. In Figure 6 the regions 8 are indicated by dashed lines which in the known device were responsible of the anomalous conduction in sub-threshold region. Such regions 8 are, as shown in Figure 7, on the edge 9 of the active area 1 which has a slope of an angle smaller than a right angle with respect to the surface profile of the central part 10 of the active area 1, wherein as central part of the active area it is indicated all the active area without the edge 9. The gate finger 2 comprises a polysilicon layer 20 and a silicon oxide layer 11; the last can present a higher thickness over the central part 10 and a lower thickness on the edge 9 of the active area 1. It is possible that the dopant concentration of the active area 1 is higher in the central part 10 than in the edge 9.

The MOS semiconductor device according to invention comprises at least one pair of prolongations 51 of the gate finger which are substantially transversal to the gate finger 2 or parallel to the formation of the channel of the MOS transistor M1 under the gate finger 2. Said prolongations 51 derive from the sides 49 of the gate finger which are opposite to each other and which are transversal to the formation of the channel and said prolongations 51 are placed above portions 48 of the edge 9 which are parallel to the formation of the channel and upper portions of the central part 10 of the active area 1, which are indicated by 21, which are adjacent to the portions 48, as shown in more detail in Figure 7. The prolongations 51 are in electric contact with the gate finger 2.

More specifically the device according to invention comprises at least two pairs of prolongations 51 of the gate finger which are substantially transversal to the gate finger 2 or parallel to the formation of the channel of the MOS transistor M1 under the gate finger 2. Said prolongations 51 derive from the sides 49 of the gate finger which are opposite to each other and which are transversal to the formation of the channel and said prolongations 51 are placed above portions 48 of the edge 9 which are parallel to the formation of the channel and above portions of the central part 10 of the active area 1, which are indicated by 21, which are adjacent to the portions 48. The prolongations 51 are in electric contact with the gate finger 2.

The device according to the embodiment in Figure 6 comprises an entire gate ring 50 comprising the pairs of prolongations 51 and portions 52 constituted by the polysilicon layer 20 and by the silicon oxide layer 11. Said portions 52 are placed between the free ends of the four prolongations 51; also said portions 52 are parallel to the gate finger 2 or transversal to the formation of the channel of the MOS transistor M1 and are arranged above the portions 47 of the edge 9 of the active area 1 which are parallel to the gate finger 2 or transversal to the formation of the channel and above the portions 22 of the central part 10 of the active area 1 which are next the edge 9, as shown in more detail in Figure 8. The portions 52 are in electric contact with the portions 51 and the portions 48 extend for all the length of the part of the edge 9 of the active area which is parallel to the formation of the channel.

In such way a single MOS transistor Minv is formed in addition to the main MOS transistor M1 which is provided with a modulation of the thickness of the gate oxide. Such transistor Minv in fact comprises a source region constituted by the region 4 or 5 of the active area 1, a drain region constituted respectively by the region 5 or 4 and a gate region constituted by the gate of the region 8, by the prolongations 51 and by the portions 52; all the gate region of the transistor Minv has a modulation of the thickness of the gate oxide because it is provided with zones with thiner oxide layer 11 (the part of the oxide layer 11 which finds over the edge 9 of the active area 1, that is over the portions of the edge 9 which belong to the regions 8, over the edge portions 48 and over the edge portions 47) and zones with thicker oxide layer 11 (the part of the oxide layer 11 which finds over the portions 21 and 22 of the central part 10 of the active area 1); the substrate 100 finds under the gate region of the transistor Minv and the formation of the channel of the transistor Minv occurs. In such way since the threshold voltage of the transistor Minv is given by the higher threshold voltage of the single elements composing the transistor Minv and since the threshold voltage depends on the thickness of the silicon oxide layer 11, because the thickness of the silicon oxide layer 11 of the portions 21 and 22 is equal to the thickness of the oxide layer 11 of the gate finger 2 over the central part 10 of the active area 1, the threshold voltage of the transistor Minv is equal to the threshold voltage of the main MOS transistor M1. In such way the transistor Minv will turn on with the turning on of the MOS transistor M1 thereby solving the problems due to a high turning off current and to a relatively high power consumption which verified with the known device in Figure 1.

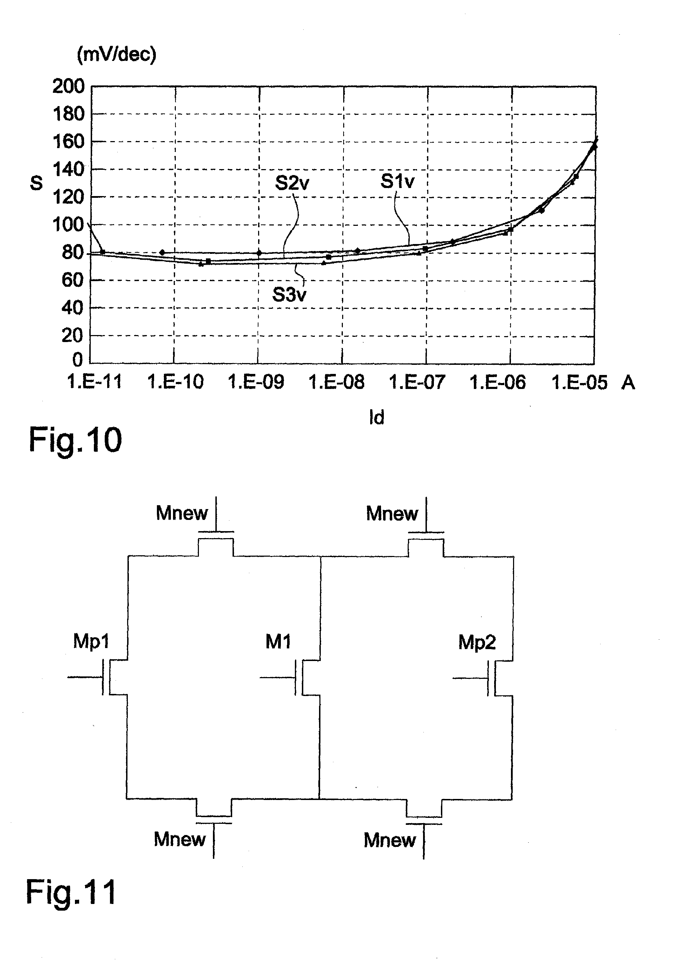

The effect of the two pairs of prolongations 51 of the gate finger 2 is circuitally comparable to the effect of a circuit structure comprising further transistors Mnew arranged in series with the parasitic transistors Mp 1 and Mp2 of the regions 8; the series of two transistors Mnew and of one of the transistors Mp1 and Mp2 is parallel to the main transistor M1 (as schematically shown in Figure 11); the effect of the transistor Mnew is that of cancelling the effect of the parasitic transistors Mp1 and Mp2 because the threshold voltage of the transistor Mnew is higher than the threshold voltage of each parasitic transistor.

The improvement achieved by means of the device according to invention as shown in Figure 6 with respect to the known device in Figure 1 is shown in the diagrams in Figures 9 and 10. The current Id does not have a behaviour with not constant rectilinear slope in sub-threshold voltage state, as shown in Figure 9 wherein the waveform of the current Id as a function of the gate voltage Vg according to the different substrate bias voltages Vb (that is Id1v with Vb=0, Id2v with Vb=-0.5V and Id3v with Vb=-1V) is shown. Figure 10 shows the slope S given by dVg/(dlog(Id)) ( at millivolt/decade) as a function of the current Id according to the different substrate bias voltages Vb (that is S1v with Vb=0, S2v with Vb=-0.5V and S3v with Vb=-1V).

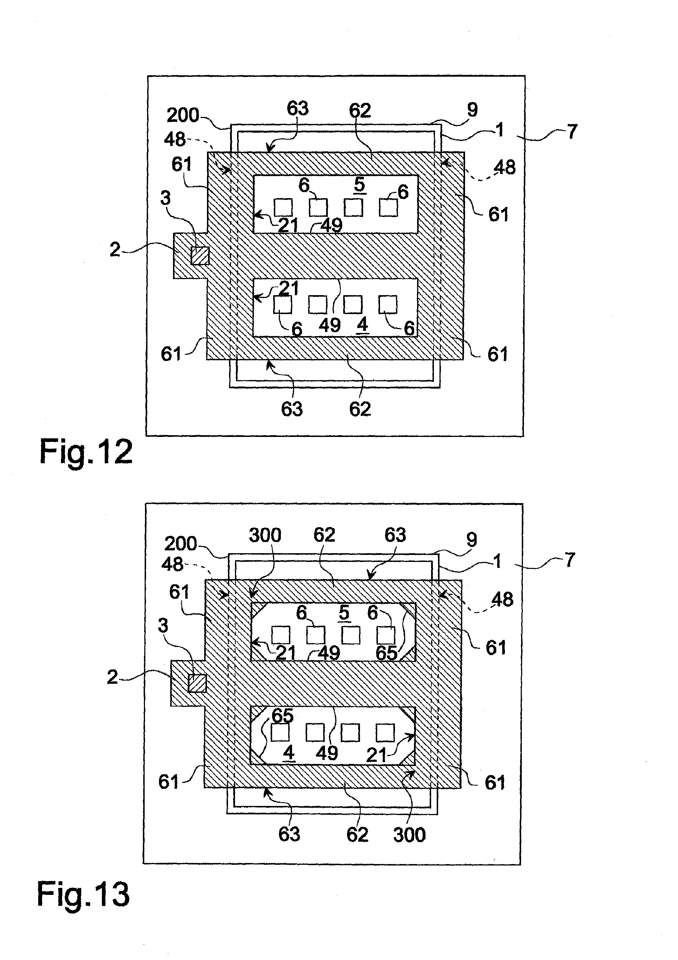

In Figure 12 a layout of a MOS semiconductor device according to a second embodiment of the invention is shown. The device in Figure 12 differs from the device in Figure 6 because it comprises prolongations 61 which are similar but with a lower length than the prolongations 51 of the device in Figure 6. Said prolongations 61 extend over the portions 48 of the edge 9 of the active area 1 but said portions 48 do not extend for all the part of the edge 9 which is parallel to the formation of the channel of the transistor M1 or transversal to the gate finger 2.

The device in Figure 12 comprises also portions 62, each one of which is always constituted by a portion of the polysilicon layer 20 and by a underlying portion of the silicon oxide layer 11. Each portion 62 is not placed over a portion 47 of the edge 9 of the active area 1, but only over a portion 63 of the central part 10 of the active area 1, beyond the contact areas 6 and again in a way transversal to the formation of the channel of the MOS transistor M1. The goal of the device of the second embodiment of the invention is to avoid the deposition of polysilicon and silicon oxide portions over the angles 200 of the active area 1 for improving the reliability of the device.

In Figure 13 a layout of a MOS semiconductor device according to a variant of the second embodiment of the invention is shown. The device in Figure 13 differs from the device in Figure 12 for the presence of portions 65 of the polysilicon layer 20 and of the silicon oxide layer 11 which are placed over the angles 300 formed by means of the intersections of the prolongations 61 with the portions 62 and with the gate finger 2. In the device in Figure 13 it is possible to form a way out for the polysilicon layer 20 and the oxide layer 11 so as not to form angles with right edges towards the inside of the device for improving further the reliability of the device. It is even possible, even if not shown in Figures, to placed portions 65 of the polysilicon layer 20 and silicon oxide layer 11 over the angles formed by the intersections of the prolongations 51 with the portions 52 and with the gate finger 2 in the MOS semiconductor device shown in Figure 6.

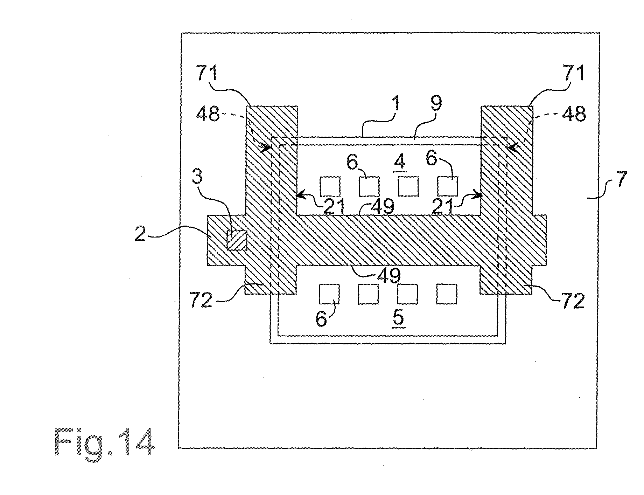

In Figure 14 a layout of a MOS semiconductor device according to a third embodiment of the invention is shown. The device in Figure 14 differs from the device in Figure 6 for the lack of the portions 52 and for the presence of prolongations 71 similar to the prolongations 51 and of prolongations 72 similar to the prolongations 51 but having a lower length. In Figure 14 a device comprising a pair of prolongations 71 over some portions 48 of the edge 9 and over adj acent portions 22 of the central part 10 of the part 5 of the active area 1. The portions 48 underlying the prolongations 71 and 72 do not extend for all the part of the edge 9 which is parallel to the formation of the channel of the transistor M1 or transversal to the gate finger 2. The pairs of the prolongations can be not symmetric, that is the pair of prolongation over the portions of the edge 9 and the portions of the central part 10 of the part 4 and of the part 5 of the active area 1 are formed by means of a prolongation 71 with a prolongation 72. The device in Figure 14 is implemented above all in the case of the use of a MOS transistor M1 having minimum sizes, that is with minimum channel length, because the length of the channel of each one between the parasitic transistors Mp1 and Mp2 can be considered greater than the channel length of the transistor M1. For example the entire length of a prolongation 71 with a prolongation 72 can be twice greater than the minimum length of the channel of the MOS transistor M1.

According to the present invention it is possible to form a method for manufacturing a MOS device wherein it occurs a first step for forming over a semiconductor material substrate 100 a semiconductor region 1 assigned to become the active area of the MOS device; said semiconductor region comprising a central part 10 and an edge 9 having a inclined surface with respect to the central part 10, as shown in figures 6-8, 12-14.

The method comprises a second step for forming a gate finger 2 placed over of the central part 10 of said region 1 wherein the gate finger 2 comprises an insulating material layer 11 adjacent to the region 1 and a conductive material layer 20 over said insulating material layer 11. The second step comprises, simultaneously with the formation of the gate finger 2, the formation of at least one first pair of prolongations 51, 61, 71, 72 of the gate finger 2 which derive from both its sides 49 parallel to the main direction of the finger 2. The first pair of prolongations 51, 61, 71, 72 are placed over portions 48 of the edge 9 of said region 1 which are transversal to said sides 49 of the gate finger 2 and over their adjacent portions 21 of the central part 10 of said region 1.

More specifically the second step comprises the formation of a first and a second pair of prolongations 51, 61, 71, 72 of said gate finger 2 which derive from both its sides 49 parallel to the main direction of the finger 2; the two pairs of prolongations 51, 61, 71, 72 are placed over portions 48 of the edge 9 of said region 1 which are transversal to said sides 49 of the gate finger 2 and over their adjacent portions 21 of the central part 10 of said region 1.

Said second step can comprise also, again simultaneously with the formation of the gate finger 2, the formation of a first and a second portions 52, 62 of said conductive material layer 20 and of insulating material layer 11; the first portion 52, 62 and the second portion 52, 62 are arranged respectively between the free ends of the prolongations 51, 61, in electric contact with them and according to a direction transversal to main direction of the gate finger 2.

After said second step it occurs the implant of the source and drain regions 101 of the MOS semiconductor device inside the zones of the substrate which are not covered by the polysilicon 20 and the silicon oxide 11.

In one embodiment of the invention the first and a second portions 52 are placed over further portions 47 of the edge 9 of said region 1 and over further adjacent portions 22 of the central part 10, as shown in Figures 6-8.

In another embodiment of the invention the first and second portions 62 are placed over other portions 63 of the central part 10 of the said region 1, as shown in Figures 12 and 13.

## Claims

1. MOS semiconductor device comprising an active area (1) of semiconductor material, said active area (1) comprising a central part (10) and an edge (9) having a inclined surface with respect to the central part (10), said MOS device comprising a gate finger (2) placed over of the central part (10) of said active area and formed by an insulating material layer (11) adjacent to the active area (1) and a conductive material layer (20) over said insulating material layer (11), **characterized by** comprising at least one first pair of prolongations (51, 61, 71, 72) of said gate finger (2) which derive from both its opposite sides (49) transversal to the formation of the channel under the gate finger (2) and which are in a direction substantially parallel to the formation of said channel, said first pair of prolongations (51, 61, 71, 72) being placed over portions (48) of the edge (9) of the active area (1) which are parallel to the formation of said channel and over their adjacent portions (21) of the central part of the active area (1).

2. Device according to claim 1, **characterized by** comprising a first and a second pair of prolongations (51, 61, 71, 72) of said gate finger (2) which derive from both its opposite sides (49) transversal to the formation of the channel under the gate finger (2) and which are in a direction substantially parallel to the formation of said channel, said two pairs of prolongations (51, 61, 71, 72) being placed over portions (48) of the edge (9) of the active area (1) which are parallel to the formation of said channel and over their adjacent portions (21) of the central part of the active area (1).

3. Device according to claim 2, **characterized in that** said portions (48) of the edge (9) of the active area (1) extend for all the part of he edge (9) which is parallel to the formation of the channel under the gate finger (2), said two pairs of prolongations (51, 71) covering entirely said portions (48) of the edge (9) of the active area.

4. Device according to claim 2, **characterized in that** said portions (48) of the edge (9) of the active area (1) have sizes smaller than the part of the edge (9) which is parallel to the formation of the channel under the gate finger (2), said two pairs of prolongations (61, 72) covering entirely said portions (48) of the edge (9) of the active area.

5. Device according to claim 3 or 4, **characterized in that** the prolongations (51,61) belonging to said first pair or to said second pair of prolongations (51, 61) have equal sizes.

6. Device according to claim 3 or 4, **characterized in that** the prolongations (71, 72) belonging to said first pair or to said second pair of prolongations (71, 72) have different sizes.

7. Device according to claim 3, **characterized by** comprising a first and a second portions (52) of said conductive material layer (20) and of said insulating material layer (11), said first portion (52) and said second portion (52) being arranged respectively between the free ends of the prolongations (51) of said first and second pairs of prolongations (51), in electric contact with them, according to a direction transversal to the formation of the channel under the gate finger (2) and over further portions (47) of the edge (9) of the active area (1) and over further adjacent portions (22) of the central part (10) of the active area (1).

8. Device according to claim 4, characterized comprising a first and a second portions (62) of said conductive material layer (20) and of insulating material layer (11), said first portion (62) and said second portion (62) being arranged respectively between the free ends of the prolongations (61) of said first and second pairs of prolongations (61), in electric contact with them, according to a direction transversal to the formation of the channel under the gate finger (2) and over other portions (63) of the central part (10) of the active area (1).

9. Device according to claim 7 or 8, **characterized by** comprising further portions (65) of said conductive material layer (20) and of insulating material layer (11) which are placed over the angles (300) formed by the intersections of the prolongations (51, 61) of said first and second pairs of prolongations (51, 61) with said first portion (52, 62), said second portion (52, 62) and said gate finger (2).

10. Method for manufacturing a MOS device, said method comprising a first step for forming over a semiconductor material substrate (100) a semiconductor region (1) assigned to become the active area (1) of the MOS device, said semiconductor region comprising a central part (10) and an edge (9) having a inclined surface with respect to the central part (10), a second step for forming a gate finger (2) placed over of the central part (10) of said region (1), said gate finger (2) being formed by means of a insulating material layer (11) adjacent to said region (1) and a conductive material layer (20) over said insulating material layer (11), **characterized in that** the second step comprising, simultaneously with the formation of the gate finger (2), the formation of at least one first pair of prolongations (51, 61, 71, 72) of said gate finger (2) which derive from both its sides (49) parallel to the main direction of the finger (2), said first pair of prolongations (51, 61, 71, 72) being placed over portions (48) of the edge (9) of said region (1) which are transversal to said sides (49) of the gate finger (2) and over their adjacent portions (21) of the central part (10) of said region (1).

11. Method according to claim 10, **characterized in that** said second step comprises the formation of a first and a second pair of prolongations (51, 61, 71, 72) of said gate finger (2) which derive from both its sides (49) parallel to the main direction of the finger (2), said two pairs of prolongations (51, 61, 71, 72) being placed over portions (48) of the edge (9) of said region (1) which are transversal to said sides (49) of the gate finger (2) and over their adjacent portions (21) of the central part (10) of said region (1).

12. Method according to claim 11, **characterized in that** said second step comprises, contemporaneously to the formation of the gate finger (2), the formation of a first and a second portions (52) of said conductive material layer (20) and of said insulating material layer (11), said first portion (52) and said second portion (52) being arranged respectively between the free ends of the prolongations (51) of said first and second pairs of prolongations (51), in electric contact with them, according to a direction transversal to main direction of the gate finger (2) and over further portions (47) of the edge (9) of said region (1) and over further adjacent portions (22) of the central part (10) of the said region (1).

13. Method according to claim 10, **characterized in that** said second step comprises, simultaneously with the formation of the gate finger (2), the formation of a first and a second portions (62) of said conductive material layer (20) and of insulating material layer (11), said first portion (62) and said second portion (62) being arranged respectively between the free ends of the prolongations (61) of said first and second pairs of prolongations (61), in electric contact with them, according to a direction parallel to main direction of the gate finger (2) and over other portions (63) of the central part (10) of the said region (1).
